Europäisches Patentamt

(19) European Patent Office

Office européen des brevets

(11) Veröffentlichungsnummer : **0 048 796**
**B1**

(12) **EUROPÄISCHE PATENTSCHRIFT**

(45) Veröffentlichungstag der Patentschrift :
**17.10.84**

(21) Anmeldenummer : **81105099.6**

(22) Anmeldetag : **01.07.81**

(51) Int. Cl.³ : **H 03 K 4/62**, H 04 N 3/16

(54) Schaltungsanordnung zur Erzeugung eines sägezahnförmigen Stromes.

(30) Priorität : **27.09.80 DE 3036573**

(43) Veröffentlichungstag der Anmeldung :
**07.04.82 Patentblatt 82/14**

(45) Bekanntmachung des Hinweises auf die Patenterteilung : **17.10.84 Patentblatt 84/42**

(84) Benannte Vertragsstaaten :
**BE DE FR GB IT NL**

(56) Entgegenhaltungen :
**DE-A- 2 046 015
DE-A- 2 258 132
GB-A- 1 187 500
US-A- 3 512 040
SERVICESCHRIFT 1700/109/01 DES NORDMENDE-
ZENTRAL-KUNDENDIENSTES SERVICE INFORMA-
TION: CHASSIS F7 779.535 A/B/C/K/J SK3
FUNKSCHAU, Nr. 5, 1975, R. DANGSCHAT et al. "Ein
Sperrwandler-Netzmodul mit Netztrennung", Seiten
40 bis 43**

(73) Patentinhaber : **Norddeutsche Mende Rundfunk KG
Funkschneise 5-9
D-2800 Bremen-Hemelingen (DE)**

(72) Erfinder : **Ricken, Heinz-Günter
Fratenkamp 7
D-2800 Bremen-Mahndorf (DE)**

EP 0 048 796 B1

Jouve, 18, rue St-Denis, 75001 Paris, France

**Beschreibung**

Die Erfindung betrifft eine Schaltungsanordnung zur Erzeugung eines sägezahnförmigen Stromes für die Ablenkung von Elektronenstrahlen in einer Bildröhre, vorzugsweise eines Fernsehempfängers, bestehend aus einem elektronischen Schalter und einem Belastungskreis, wobei der elektronische Schalter aus einem Schalttransistor mit einer seiner Basis-Emitter-Strecke anti-parallel geschalteten Diode gebildet wird und der Belastungskreis zumindest aus dem Ablenksatz und einer diesem parallel liegenden Kapazität besteht und die Steuerung des elektronischen Schalters durch einen Thyristor erfolgt, dessen Kathode mit dem Emitter des Schalttransistors verbunden ist und dessen Zündelektrode Synchronisierimpulse zuführbar sind.

Stand der Technik

Nach dem allgemein bekannten Stand der Technik bestehen Schaltungsanordnungen für die Horizontalablenkung in Fernsehgeräten, soweit sie mit Transistoren arbeiten, im allgemeinen aus einer Endstufe mit einem Schalttransistor, der über einen Transformator durch eine Treiberstufe geschaltet wird. Die Treiberstufe ihrerseits erhält ihren Steuerstrom über Impulsformerglieder aus einem integrierten Schaltkreis, z. B. des Typs TDA 2593, der u. a. Impulsabtrennstufen, Zeilenoszillator, Phasenvergleich und relativ kräftige Endstufen besitzt, um den Steuerstrom für die Treiberstufe aufzubringen (ca. 150 mA). Eine solche Schaltung ist z. B. in der Serviceschrift 1700/109/01 des NORDMENDE Zentralkundendienstes, Service-Information Chassis F7 779.535 A/B/C/K/J, SK3, aufgeführt.

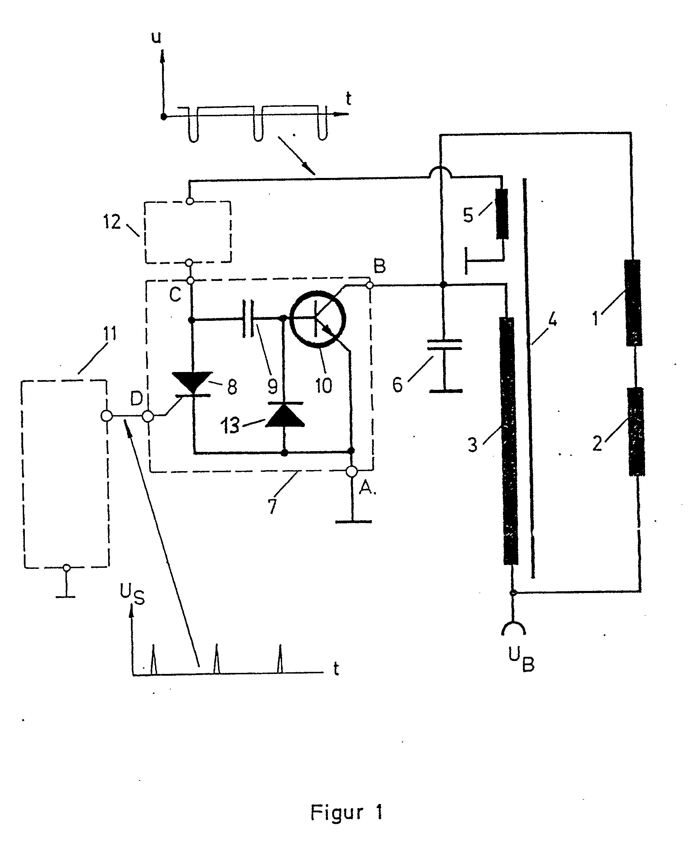

Es ist auch bekannt, z. B. aus Fig. 1 der DT-OS 22 58 132 in Reihe mit der Basis eines Schalt-Transistors für eine Horizontal-Ablenkung eine Induktivität zu legen, die die Aufgabe hat, bei Umpolung des dort angeführten Transformators 18 zum Zwecke des Einleitens des Abschalt-Vorganges den Basisstrom des Transistors 12 nach einer E-Funktion allmählich abzubauen. Der Abbau des Basisstroms nach einer E-Funktion hat den Nachteil, daß am Ende des Ausräum-Prozesses der Abbau langsam vonstatten geht und beim Einsetzen des kollektorseitigen Abschalt-Vorganges noch Ladungsträger im Basisraum vorhanden sind, was zu einer unzulässigen Erwärmung des Transistors führen kann.

Ausserdem ist in o. a. Fig. 1 auch eine Diode 20 bekannt, die der Basis-Emitter-Strecke des Transistors parallel liegt und die Aufgabe hat, während der ersten Hälfte der Hinlauf-Periode die Basis-Emitter-Strecke des Transistors 12 zu überbrücken und den Durchbruchsbetrieb zu vermeiden.

· Es ist auch bekannt, einen Schalt-Transistor dadurch zum Abschalten zu bringen, daß seine Basis-Emitterstrecke durch einen 2. Schalter kurzgeschlossen wird.

Die DE-OS 20 46 015 zeigt in Fig. 1 den Transistor 9 und in Fig. 3 den Feldeffekt-Transistor 19, die beide eine solche Kurzschluß-Funktion bewirken.

Die angegebenen Schaltungen der DE-OS 20 46 015 enthalten nicht die für die Schalt-Transistoren für grössere Leistungen erforderlichen Mittel zur Ausräumung des Basisraumes beim Abschalten.

Der entscheidende Nachteil aller dieser Schaltungen ist aber das Fehlen des Koppelkondensators zwischen dem Kollektor des Transistors 9 bzw. 19 und der Basis des Schalttransistors 1 bzw. 21.

Erst durch die Einführung des Koppelkondensators ist es möglich, eine definierte Resonanz zwischen der induktiv wirkenden Rückkopplungsimpedanz und dem Koppelkondensator herbeizuführen, mit der ein besonders günstiger Verlauf des Ansteuerstromes für den Schalttransistor erreichbar ist.

Zwar ist auch in der DE-OS 20 46 015 ein Rückkopplungs-Widerstand 20 angegeben, der auch ein Blindwiderstand sein kann. Er hat aber lediglich die Aufgabe, den Strom zu begrenzen.

Bei der GB-PS 11 87 500 ist bereits ein Thyristor zum Kurzschliessen der Basis-Emitter-Strecke vorgesehen. Es fehlen jedoch die Mittel zur Ausräumung des Basisraumes beim Abschalten des oben beschriebenen Koppelkondensators. Es handelt sich ausserdem um eine fremdgesteuerte Einrichtung mit einem erheblichen Aufwand.

Die US-PS 35 12 040 zeigt eine selbstschwingende Anordnung für die Horizontal-Ablenkung eines Fernsehgerätes, die mittels der Zünd-Elektrode eines Thyristors gesteuert wird. Die aufgeführte Diode 31 liegt jedoch nicht parallel zu der Basis-Emitter-Strecke des Schalt-Transistors 36, sie hat lediglich die Aufgabe, die Aufladung des Kondensators 32 vorzunehmen.

Der Kondensator 32 selbst liegt nicht in einem Reihenresonanzkreis, der von dem Abgriff des Belastungskreises über eine induktiv wirkende Rückkopplungsimpedanz zur Basis des Schalttransistors führt. Die Steuerung der Basis des Schalttransistors erfolgt über eine Kette ohmscher Widerstände 39 und 40. Um den notwendigen Basisstrom aufzubringen, müssen diese Widerstände relativ niederohmig sein. Es wird eine große Leistung in Wärme umgesetzt. Die Aufgabe, eine energiesparende Schaltung zu finden, wird nicht erfüllt.

Aus der Applikationsschrift der Firma SIEMENS, UBB Vertrieb, Anwendungslabor R. Dangschat/H. Ammon/H. Grobecker vom 8. März 1974 « AZB 5000 Sperrwandler-Netzmodul mit Netztrennung » ist es weiterhin bekannt, die Anode eines Thyristors (BRY 55) über einen Koppelkondensator (47 μF) mit der Basis eines Schalttransistors (BU 126) zu verbinden. Es handelt sich dabei um ein Schaltnetzteil mit lastabhängiger Frequenz und lastabhängigem Tastverhältnis und nicht um eine Schaltungsanordnung zur Erzeugung eines sägezahnförmigen Stromes konstanter Frequenz und konstantem Tastverhältnis für die Ablenkung von Elektronenstrahlen. Der für die Basisansteuerung des Schalttransistors vorteilhafte Reihenresonanzkreis aus induktiver Rückkopplungsimpedanz und Koppelkondensator fehlt. Die Schaltung benötigt für die Vorspannung des Koppelkondensators eine eigene Spannungsquelle und die Kathode des Thyristors kann nur über die Parallelschaltung eines Kondensators 0,68 μF mit einem Widerstand 1 Ohm mit dem Emitter des Schalttransistors verbunden werden. Die Schaltung ist also aufwendig.

## Aufgabe

Es besteht die Aufgabe, eine energiesparende Schaltungsanordnung zur Erzeugung eines sägezahnförmigen Stromes für die Ablenkung von Elektronenstrahlen in einer Bildröhre zu finden, die möglichst wenig Bauteile enthält und somit zuverlässiger ist als Schaltungsanordnungen nach dem Stand der Technik, die wegen ihres geringen Aufwandes an Lohn (Entfall eines teuren Wickelteils) und Material kostengünstiger ist und die zu ihrer Ansteuerung nur einen minimalen Strom von einigen Mikroampere benötigt, so daß auch die bisher üblichen Leistungsendstufen in den die Anordnung steuernden integrierten Schaltkreisen, die einen grossen Teil der Chipfläche benötigen und vorwiegend zur Erwärmung der integrierten Schaltkreise beitragen, entfallen können.

## Lösung der Aufgabe

Die Aufgabe wird im Grundsatz durch die im Kennzeichen des Anspruchs 1 angegebenen Mittel gelöst.

In den weiterführenden Kennzeichen der Ansprüche 2 bis 4 werden überraschend einfache Lösungen von Randproblemen angegeben, die für den praktischen Betrieb der Schaltungsanordnung von ausserordentlicher Bedeutung sind.

## Vorteile

Eine ganze Treiberstufe, einschliesslich Treibertransformator, entfällt. Zur Ansteuerung werden lediglich zeilenfrequente kurze Impulse geringen Energieinhalts zur Zündung des Thyristors benötigt. Die steuernden integrierten Schaltkreise werden kaum noch belastet. Sie bleiben kälter und können im Grunde einfacher und kostengünstiger aufgebaut werden.

Die Gesamtschaltung ist ausserordentlich einfach, energiesparend und von übersichtlicher Funktion. Die wenigen Bauteile garantieren eine hohe Zuverlässigkeit, ihre Belastung ist minimiert. Die bisher kritische Belastung des Basiskreises des Schalttransistors ist durch die getrennte Dimensionierbarkeit der Betriebsströme für Hinlauf und Rücklauf (Speicherzeit) durch Drossel- und Speicher-Spule in Verbindung mit dem Koppelkondensator absolut unkritisch geworden. Der Schalttransistor bedarf nur eines minimalen Kühlaufwandes.

Die Schaltungsanordnung läßt sich sehr einfach auf die praktischen Belange erweitern. Das « Anlassen » der Schaltung beim Einschalten des Gesamtgerätes erfolgt mit einem einfachen RC-Glied. An die Basis des Schalttransistors lassen sich in einfacher Weise Schutzschaltungen anschliessen, die bei einer Betriebsstörung im Gesamtgerät die Horizontal-Ablenkschaltung abschalten. Damit lassen sich alle Auflagen der Sicherheitsbehörden ohne wesentliche Kosten und ohne technische Schwierigkeiten erfüllen.

## Erläuterung der Erfindung

Figur 1 zeigt das Grundprinzip der Erfindung bei Vorhandensein eines Zeilenausgangstransformators. Das Grundprinzip ist jedoch nicht auf das Vorhandensein eines Zeilenausgangstransformators beschränkt. Es ist durchaus möglich, z. B. auf dem Ablenksatz selbst Abgriffe oder entsprechende Hilfswicklungen vorzusehen, an die eine Rückkopplungsimpedanz angeschlossen ist. Auch z. B. im Fußpunkt des Ablenksatzes angeordnete Hilfsspulen, Abgriffe an kapazitiven Spannungsteilern und überhaupt alle von Oszillatoren bekannten Rückkopplungs-Anordnungen sind im Grundsatz bei der vorliegenden Schaltungsanordnung möglich.

Die angeführte Anordnung mit einem Zeilenausgangstransformator zeigt nur ein mögliches Ausführungsbeispiel.

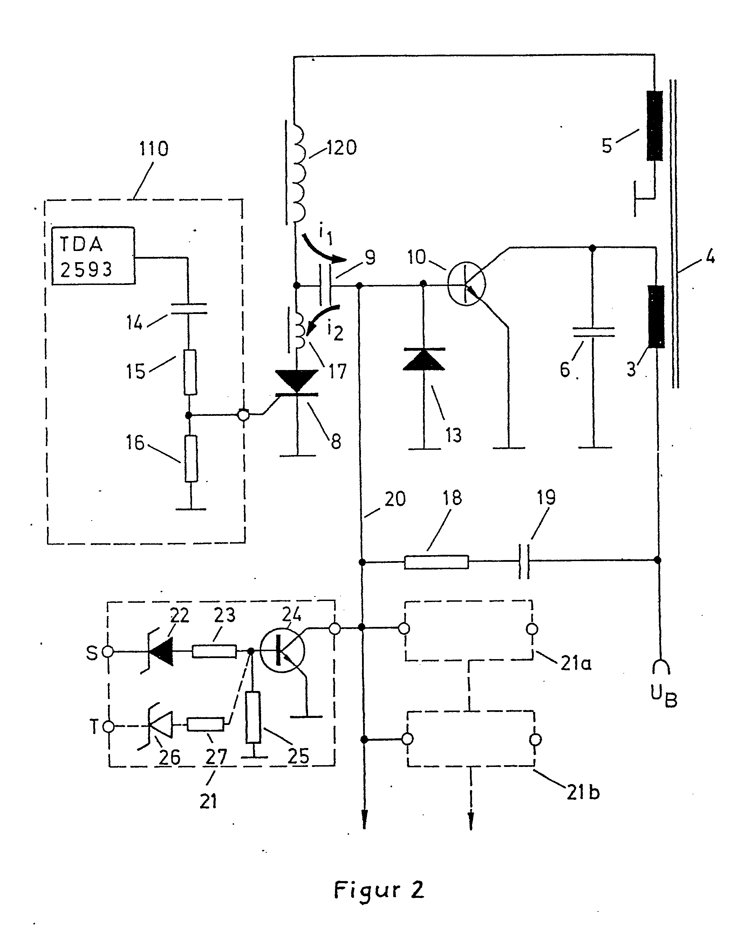

Figur 2 zeigt eine ausgeführte Schaltung.

In Figur 1 liegen die beiden Hälften 1 und 2 des Ablenksatzes für die Horizontalablenkung der Bildröhre an der Primärwicklung 3 des Zeilenausgangstransformators 4. Die beiden Ablenksatzhälften 1 und 2 können aber genauso gut an einer getrennten Sekundärwicklung liegen oder an einem Anzapf der Primärwicklung 3 oder einer anderen Wicklung.

Der Zeilenausgangstransformator 4 trägt im allgemeinen noch weitere Wicklungen, z. B. für die Hochspannungserzeugung und die Betriebsspannungserzeugung für Kleinsignalteile des Gesamtgerätes, usw... Diese Wicklungen sind jedoch in Figur 1 nicht gezeichnet, da sie für das zu erklärende Grundprinzip ohne Bedeutung sind. Gezeichnet ist jedoch die Rückkopplungswicklung 5, die, wie später erklärt, von Bedeutung ist.

Wechselstrommässig parallel zum Ablenksatz 1 und 2 und zum Zeilenausgangstransformator liegt in bekannter Weise ein Kondensator 6, der zusammen mit der Schaltungskapazität die Rücklaufzeit der Zeilenablenkung bestimmt.

Um einen sägezahnförmigen Stromverlauf im Ablenksatz 1 und 2 zu erzeugen, ist es üblich, dem bisher beschriebenen System in der zweiten Hälfte des sägezahnförmigen Hinlaufs Energie dadurch zuzuführen, daß das System mittels eines elektronischen Schalters an eine Quelle konstanter Betriebsspannung $U_B$ angeschlossen wird. Um den Hinlauf zu beenden, muß diese Energiezufuhr durch diesen elektronischen Schalter unterbrochen werden, wodurch das System sich selbst überlassen bleibt und als Schwingkreis eine halbe Sinusschwingung vollführt. Nach Vollendung dieser halben Sinusschwingung sorgt normalerweise eine Diode dafür, daß das System wieder an die konstante Betriebsspannung $U_B$, jedoch in umgekehrter Stromrichtung, angeschlossen wird. Diese dem Zeilenausgangstransformator bekannterweise parallel liegende Diode ist in Figur 1 gar nicht mehr gezeichnet, weil sie in der erfindungsgemässen Schaltungsanordnung vorteilhafterweise weggelassen werden kann. Sie wird durch die Kollektor-Basis-Diode des Schalttransistors 10 und durch die viel kleinere Diode 13, die der Basis-Emitter-Diode des Schalttransistors anti-parallel liegt, ersetzt.

Neuartig an der erfindungsgemässen Schaltungsanordnung ist nun, daß in dem elektronischen Schalter 7, der einen Thyristor 8 enthält, dessen Kathode mit dem Emitter eines Schalttransistors 10 verbunden ist, die Anode des Thyristors über einen Koppelkondensator 9 mit der Basis des Schalttransistors 10 und mit einer induktiv wirkende Rückkopplungsimpedanz 12 verbunden ist, wobei beide Bauteile einen Reihenschwingkreis bilden, dessen Resonanzfrequenz tiefer als die Frequenz des zu erzeugenden sägezahnförmigen Stromes ist.

Die Schaltverbindung an den Klemmen A und B des elektronischen Schalters wird geöffnet, wenn an die Klemme D ein kurzer positiver Impuls gelegt wird. Die Schaltverbindung wird hergestellt, wenn an der Klemme C für die Dauer dieser Schaltverbindung ein positiver Strom eingespeist wird, dem jedoch eine negative Spannungsspitze vorausgegangen sein muß, damit der gezündete Thyristor 8 gelöscht wird.

In umgekehrter Stromrichtung ist die Schaltverbindung A-B des elektronischen Schalters 7 immer geschlossen durch einen möglichen Stromfluß in Durchlassrichtung, durch die Kollektor-Basis-Diode des Schalttransistors 10 und anschließend durch die der Basis-Emitter-Diode anti-parallel geschalteten Diode 13.

Die Schaltverbindung A-B des elektronischen Schalters 7 wird durch eine externe Schaltung 11 mittels kurzer positiver Impulse an der Klemme D geöffnet. Die externe Schaltung 11 ist im allgemeinen ein integrierter Schaltkreis, der z. B. Impulsabtrennstufen, Zeilen-Oszillator, Phasenvergleichsstufen und Ausgangsstufen mit entsprechenden Pulsformerstufen enthält. Wie bekannt, wird zum Zünden von Thyristoren nur eine sehr kleine Leistung benötigt. Die Ausgangsstufen der externen Schaltung benötigen nur eine kleine Chipfläche und gegenüber den heute verwendeten integrierten Schaltungen, z. B. den Typen TDA 2593 oder ähnlichen, die eine Ausgangsleistung von etwa 0,6 bis 0,7 Watt abgeben können, werden ganz erhebliche Einsparungen möglich, da nur noch Mikrowatts benötigt werden.

Das Schließen der Schaltverbindung A-B des elektronischen Schalters 7 durch eine negative Spannungsspitzean der Klemme C und nachfolgenden Stromfluß in umgekehrter Richtung kann grundsätzlich durch eine weitere externe Schaltung bewirkt werden. Diese weitere externe Schaltung könnte ein entsprechend ausgelegter integrierter Schaltkreis sein.

Ein solcher weiterer externer Schaltkreis wird aber gar nicht benötigt, da dem Belastungskreis selbst eine solche negative Spannungsspitze und nachfolgend ein in umgekehrter Richtung fliessender Strom entnommen werden kann.

Zu diesem Zweck ist auf dem Zeilenausgangstransformator 4 eine Rückkopplungswicklung 5 vorgesehen, die die richtigen Spannungen und Ströme über eine Rückkopplungsimpedanz 12 in die Klemme C des elektronischen Schalters 7 einspeist.

Die Rückkopplungsimpedanz 12 selbst hat nun neben der Übertragung der negativen Spannungsspitze eine weitere wichtige Aufgabe. Sie muß so beschaffen sein, daß der Stromfluß in die Basis des Schalttransistors hinein so rechtzeitig beginnt, daß zu Beginn der zweiten Hälfte des Hinlaufs der Schalttransistor 10 mit Sicherheit leitend ist. Weiterhin muß der Basisstrom des Schalttransistors 10 immer größer werden je mehr sich der Hinlauf seinem Ende nähert, weil ja da auch der Kollektorstrom immer größer wird. Es besteht die weitere Aufgabe für die Rückkopplungsimpedanz 12, den Hinlauf zu unterbrechen, wenn z. B. bei einer gestörten externen Schaltung 11 der nächstfolgende Synchronisierimpuls an der Klemme D ausbleibt und der Kollektorstrom des Schalttransistors 10 ins Ungemessene zu steigen droht. Wie diese Vielzahl von Aufgaben überraschend einfach gelöst wird, wird im folgenden beschrieben.

Figur 2 zeigt eine praktisch erprobte Schaltung.

Die Rückkopplungsimpedanz wird durch die Drosselspule 120 dargestellt. Sie erfüllt zusammen mit dem Koppelkondensator 9 alle Aufgaben, die an die Rückkopplungsimpedanz 12 (Bild 1) gestellt waren.

Sobald durch die negative Spannungsspitze der Thyristor 8 nichtleitend gemacht wurde, bilden die Drosselspule 120 zusammen mit dem Koppelkondensator 9 einen Reihenresonanzkreis, dessen Resonanzfrequenz durch entsprechende Dimensionierung der Induktivität der Drosselspule 120 und/oder des Koppelkondensators tiefer als die Zeilenfrequenz liegt.

Die Drosselspule 120 ist dann optimal dimensioniert, wenn der durch die EMK der Rückkopplungsspule 5 in die Reihenresonanz und damit in die Basis des Schalttransistors 10 injizierte Strom $i_1$ kurz vor Beginn des zweiten Teils des Hinlaufs sich fugenlos und stossfrei an den aus der Basis-Kollektor-Diode des Schalttransistors 10 zurückkommenden, sich verkleinernden und in Zeilenmitte nach Null strebenden Strom anpasst und dann nahezu eine Viertelperiode vollführend so ansteigt, daß zum Ende des Hinlaufs nahezu ein Maximum erreicht wird.

Dann ist mit der kleinstmöglichen und damit kostengünstigsten Drosselspule 120 der Schalttransistor 10 auch am Hinlaufende, also bei größtem Kollektorstrom, immer noch gut leitend.

In der Praxis hat sich bei einem Koppelkondensator 9 von etwa 3,3 μF eine Induktivität der Drosselspule von etwa 100 μH bewährt. Dann liegt die Resonanzfrequenz des Reihenresonanzkreises aus Drosselspule 120 und Koppelkondensator 9 bei etwa 8,8 kHz, also etwa bei der halben Zeilenfrequenz.

Bleiben z. B. durch eine gestörte externe Schaltung 110, die im praktischen Ausführungsbeispiel ein integrierter Schaltkreis des Typs TDA 2593 ist mit einer anschliessenden Differenzierstufe aus einem Kondensator 14 und den Widerständen 15 und 16, die Zündimpulse für den Thyristor 8 aus, so wird nach spätestens einer weiteren Viertelperiode des Reihenresonanzkreises aus Drosselspule 120 und Koppelkondensator 9 der Basisstrom Null. Ein weiterer unzulässiger Anstieg des Kollektorstroms des Schalttransistors 10 wird gestoppt.

Nach einer Weiterführung der Erfindung ist zwischen der Anode des Thyristors 8 und dem Verbindungspunkt zwischen Koppelkondensator 9 und Rückkopplungsimpedanz 12 bzw. Drosselspule 120 eine Speicherspule 17 eingeschaltet. Die Speicherspulen haben die Aufgabe, den relativ hohen Basisstrom am Ende des Hinlaufs relativ langsam abzubauen und umzukehren, nachdem der Abschaltvorgang eingeleitet wurde, und zwar in der Zeit, die bei der jeweils verwendeten Transistortype zum Ausräumen des Basisraums notwendig ist.

Bei den bekannten Schalttransistoren liegen diese Speicherspulen im allgemeinen unmittelbar in der Basisleitung.

Läge nun die Speicherdrossel 17 wie üblich unmittelbar an der Basis des Schalttransistors 10, so würde sich ihre Induktivität zu der der Drosselspule 120 addieren und müßte bei der Dimensionierung der Drosselspule 120 berücksichtigt werden. Bei einer Schaltungsanordnung gemäss Anspruch 4 und gemäss Bild 2 besteht jedoch eine saubere Trennung zwischen Hinlauf (Drosselspule 120) und Abschalt-Vorgang (Speicherspule 17).

Koppelkondensator 9 und Speicherspule 17 bilden zusammen einen weiteren Reihenresonanzkreis, der vorteilhafterweise so dimensioniert ist, daß etwa eine Viertelperiode seiner Eigenschwingung nach dem Durchschalten des Thyristors 8 vergeht, bis der Schalttransistor 10 gesperrt ist.

In dieser Viertelperiode steigt der Strom $i_2$ durch die Speicherspule 17 sinusförmig an. In bezug auf die Basis des Schalttransistors 10 subtrahiert sich dieser Strom $i_2$ vom Strom $i_1$, der durch die Drosselspule 120 in die Basis hineingeschickt wird. Im weiteren Verlauf der Viertelperiode wird $i_2$ grösser als $i_1$, der Basisstrom kehrt sich um. Durch die Schwingkreiswirkung der Reihenresonanz aus Speicherspule 17 und Koppelkondensator 9 wird der Ausräumstrom gerade dann am größten, wenn der Ausräumprozess nahezu beendet ist. Der Basisraum wird leer und der Basisstrom bricht mangels Elektronen so schnell zusammen, daß die infolge des Abschaltvorgangs des Schalttransistors 10 rasch ansteigende Kollektorspannung im Transistor kaum noch Ströme vorfindet, mit denen sie zusammen eine Wirkleistung bilden könnte. Das bedeutet wiederum eine sehr geringe Erwärmung des Schalttransistors und damit hohe Zuverlässigkeit und lange Lebensdauer. Aufwendige Kühlmittel entfallen.

In dem praktisch ausgeführten Ausführungsbeispiel nach Bild 2, ist ein Planar-Transistor der Type BU 208 verwendet, für den die Einleitung des Abschaltvorgangs etwa 7 bis 8 μsec. vor dem eigentlichen Abschaltzeitpunkt zu liegen hat. Bei einem Koppelkondensator von 3,3 μF und einer Viertelschwingungsperiode von 7 bis 8 μsec. ergibt sich eine Induktivität der Speicherspule 17 von ungefähr 7 μH.

Andere Transistortypen haben andere Ausräumzeiten. Dann muß die Speicherspule entsprechend der Viertelperiodenregel entsprechend anders dimensioniert werden. Bei Transistoren in Epitaxial-Technologie empfiehlt es sich, die Speicherspule in Richtung einer Vergrösserung der Viertelperiode zu tolerieren.

Der bisher beschriebene Teil der Schaltungsanordnung nach Bild 2 hat die Eigenschaft, nicht von selbst anzuschwingen. Sie bedarf also einer Anlass-Schaltung, die die Schaltungsanordnung beim Einschalten der Betriebsspannung $U_B$ anlässt.

In Weiterführung der Erfindung ist diese Anlass-Schaltung ein einfaches RC-Glied, bestehend aus dem Anlass-Widerstand 18 und dem Anlass-Kondensator 19.

Der Spannungsanstieg der Betriebsspannung $U_B$ beim Einschalten erzeugt in der Leitung 20, die zur Basis des Schalttransistors führt, einen positiven Spannungsstoss, der die Basis des Schalttransistors anhebt und dort einen Stromfluß bewirkt und damit die Schaltungsanordnung anwirft. Die Anlass-Schaltung 18 und 19 muß nicht an die eigene Betriebsspannungsquelle der erfindungsgemässen Schaltungsanordnung angeschlossen sein. Sie kann auch an eine andere Betriebsspannungsquelle mit positiver Spannung im Gesamtgerät angeschlossen sein, die beim Einschalten ansteigt und zu gleicher Zeit eingeschaltet wird.

Eine weitere sehr wichtige Weiterführung der Erfindung zeigt die Möglichkeiten auf, bestehende Sicherheitsvorschriften der Sicherheitsbehörden ohne größeren technischen Aufwand zu erfüllen.

Beim Eintreten eines gestörten Betriebes im Gesamtgerät, beispielsweise durch einen plötzlich auftretenden Bauteile-Fehler, können an kritischen Stellen der Gesamtschaltung Spannungs- oder auch Stromerhöhungen eintreten, die zu unzulässigen Erwärmungen führen, die Folgeschäden verursachen.

Bei einem solchen Störfall kommt es darauf an, zunächst einmal die Horizontalablenkstufen stillzusetzen. An den Zeilenausgangstransformator ist nicht nur die Hochspannungserzeugung für die Bildröhre angeschlossen, sondern es werden auch eine Reihe anderer Betriebsspannungen aus dem Zeilenausgangstransformator entnommen, die weite Teile des Gesamtgerätes speisen. An kritischen Stellen des Gesamtgerätes sind nun Spannungs- bzw. Stromwächterschaltungen angebracht, die im Störfall eine vergrösserte positive Spannung liefern.

In der Weiterführung der Erfindung sind nun an die Leitung 20, die zur Basis des Schalttransistors 10 führt und die als « Notbremse » an allen kritischen Stellen des Gesamtgerätes vorbeigeführt werden kann, Sicherheitsschaltungen 21, 21a, 21b, usw. angeschlossen, die beim Auftreten eines Störfalles die Leitung 20 nach Masse kurzschliessen. Die Basis des Schalttransistors 10 wird geerdet. Der Selbsterregungsmechanismus wird unterbrochen. Die Schaltung bleibt stehen und wird auch nicht wieder angelassen, weil die aus dem Lichtnetz gelieferte Betriebsspannung $U_B$ nicht ansteigt und das RC-Glied 18 und 19 keinen positiven Impuls an die Basis des Schalttransistors 10 liefern kann.

War die Störung nur sehr kurz, z. B. ein Hochspannungsüberschlag in der Bildröhre, so wird der Selbsterzeugungsmechanismus nicht unterbrochen. Die Schaltungsanordnung arbeitet weiter.

Bisher wurde für eine Sicherheitsschaltung immer ein Flip-Flop benötigt, also mindestens 2 Transistoren, damit der Abschaltzustand auch wirklich erhalten blieb. Der erhebliche Nachteil einer solchen bistabilen Schaltung ist das Abschalten auch bei kurzen Störungen, wie z. B. bei Hochspannungsüberschlägen.

Ein Beispiel für den Innenaufbau der Sicherheitsschaltung 21 ist ebenfalls aus Bild 2 zu ersehen. Die Klemme S ist mit dem zu überwachenden Schaltungspunkt des Gesamtgerätes verbunden. Sie führt über eine der Spannungsanpassung dienenden Zenerdiode 22 und einen Entkopplungswiderstand 23 zur Basis des Sicherheitstransistors 24 und zum Basiswiderstand 25, der die Basis mit Masse verbindet.

Hat die an die Klemme S angeschlossene Schaltung Normalspannung, dann fließt kein Strom in die Basis des Sicherheitstransistors 24 hinein. Der Kollektorstrom ist Null. Für die Leitung 20 ist der Transistor nicht existent.

Im Störfall steigt die Spannung an der Klemme S, die Zenerdiode 22 läuft über, es fliesst Basis- und damit Kollektorstrom. Die Leitung 20 wird an Masse geklemmt und die Horizontalablenkstufe ausser Betrieb gesetzt.

Bei vorliegender erfindungsgemässer Schaltungsanordnung wird auch nur ein einziger Sicherheitstransistor 24 benötigt, da die Schaltungsanordnung nicht mehr anschwingt, nachdem sie einmal ausgeschaltet wurde. Es werden auch hier in dieser Weiterführung erneut Kosten gespart.

Die Sicherheitsschaltung kann auch zur Überwachung mehrerer Schaltungsteile Verwendung finden, wenn zum Beispiel über eine weitere oder mehrere weitere Klemmen T, über weitere entsprechende Zenerdioden 26 und weitere entsprechende Entkopplungswiderstände 27 diese Schaltungsteile an die Basis des Sicherheitstransistors 24 angeschlossen sind.

Es ist auch möglich, mehrere gleichartig oder ähnlich wie die Sicherheitsschaltung 21 aufgebaute weitere Sicherheitsschaltungen 21a, 21b, usw. an die Leitung 20 anzuschliessen.

## Ansprüche

1. Schaltungsanordnung zur Erzeugung eines sägezahnförmigen Stromes für die Ablenkung von Elektronenstrahlen in einer Bildröhre, vorzugsweise eines Fernsehempfängers, bestehend aus einem elektronischen Schalter und einem Belastungskreis, wobei der elektronische Schalter aus einem Schalttransistor (10) mit einer seiner Basis-Emitter-Strecke anti-parallel geschalteten Diode (13) gebildet wird und der Belastungskreis zumindest aus dem Ablenksatz und einer diesem parallelliegenden Kapazität (6) besteht und die Steuerung des elektronischen Schalters durch einen Thyristor (8) erfolgt, dessen Kathode mit dem Emitter des Schalttransistors verbunden ist und dessen Zündelektrode Synchronisierimpulse zuführbar sind, dadurch gekennzeichnet, daß die Anode des Thyristors (8) über einen Koppelkondensator (9) mit dem basisseitigen Ende der Antiparallelschaltung der Basis-Emitter-Strecke des Schalttransistors (10) und der Diode (13) verbunden ist, daß die Anode des Thyristors (8) zusätzlich über eine als Rückkopplungsimpedanz (12) wirkende Drosselspule (120) mit einem Abgriff des Belastungskreises im rückkoppelnden Sinne verbunden ist und daß die Induktivität der Drosselspule (120) so bemessen ist, daß sie zusammen mit dem Koppelkondensator (9) einen Reihenschwingkreis bildet, dessen Resonanzfrequenz tiefer als die Frequenz des zu erzeugenden sägezahnförmigen Stromes ist.

2. Schaltungsanordnung nach Anspruch 1 dadurch gekennzeichnet, daß eine Speicherspule (17) zwischen der Anode des Thyristors (8) und dem Verbindungspunkt zwischen Koppelkondensator (9) und Rückkopplungsimpedanz (12, 120) angeordnet ist und daß die Induktivität der Speicherspule (17) so bemessen ist, daß der aus der Speicherspule (17) und dem Koppelkondensator (9) gebildete Reihenresonanzkreis eine solche Eigenresonanz hat, daß eine volle Schwingungsperiode dieses Resonanzkreises etwa viermal so lang ist wie die Zeit, die zum Abbau des Basisstroms und zum Ausräumen des Basisraums des Schalttransistors (10) während des Abschaltvorgangs benötigt wird.

3. Schaltungsanordnung nach Anspruch 1 und 2, dadurch gekennzeichnet, daß die Basis des Schalttransistors (10) über eine Reihenschaltung eines Widerstandes (18) und eines Kondensators (19) mit einer Ausgangsklemme eines Stromversorgungsteiles des Gesamtgerätes verbunden ist.

4. Schaltungsanordnung nach Anspruch 1 bis 3, dadurch gekennzeichnet, daß die Basis des Schalttransistors (10) mit einer oder mehreren Sicherheitsschaltung(en) (21) verbunden ist, die bei einem Störungsfall im Gesamtgerät die Basis mit dem Emitter des Schalttransistors (10) kurzschließt (kurzschliessen).

## Claims

1. A circuit arrangement for generating a saw-tooth current for deflecting an electron beam in a cathoderay tube, advantageously of a television set, comprising an electronic switch and a load circuit, in which the electronic switch is formed by a switching transistor (10) with a diode (13) in anti-parallel with the base-emitter path, and the load circuit is formed by at least the deflector set and a capacitor (6) parallel to this, control of the electronic switch being by a thyristor (8) the cathode of which is connected with the emitter of the transistor and the ignition electrode of which can be supplied with synchronising pulses, characterised in that the anode of the thyristor (8) is connected via a coupling capacitor (9) with that end connected to the base of the anti-parallel connection of the base-emitters path of the transistor (10) and the diode (13), that the anode of the thyristor (8) is connected additionally via a choke coil (120), acting as a feed-back impedance (12), to a point of the load circuit in a feedback sense, and that the magnitude of the inductance of the choke coil (120) is such that with the coupling capacitor (9) it forms a series resonant circuit having a resonant frequency lower than the frequency of the saw-tooth waveform to be generated.

2. A circuit arrangement according to claim 1, characterised in that a storage coil (17) is arranged between the anode of the thyristor (8) and the junction of the coupling capacitor (9) and the feed back impedance (12, 120), and that the inductance of the storage coil (17) is such that the series resonant act formed by the storage coil (17) and the coupling capacitor (9) has a resonant frequency of which one full period is about four times the length of the time required for the base current to decay and the base region to clear in the switching transistor (10) during the switch-off process.

3. A circuit arrangement according to claim 1 and 2, characterised in that the base of the switching transistor (10) is connected to an output terminal of a current source of the whole apparatus, via a resistor (18) and a capacitor (19) in series.

4. A circuit arrangement according to claim 1 to 3, characterised in that the base of the switching transistor (10) is connected to one or more safety circuit(s) (21) which, upon occurence of a disturbance of the whole apparatus, short circuit the base and emitter of the switching transistor (10).

## Revendications

1. Circuit générateur de courant en dents de scie pour la déviation de rayons électroniques dans un tube à images, de préférence pour un récepteur de télévision, comportant un commutateur électronique et un circuit de charge, le commutateur électronique étant formé par un transistor de commutation (10) sur le trajet base-émetteur duquel on branche une diode (13) en antiparallèle, le circuit de charge comprenant au moins le bloc de déviation et un condensateur (6) branché en parallèle sur ce dernier, et la commande du commutateur électronique étant effectuée à l'aide d'un thyristor (8) dont la cathode est reliée à l'émetteur du transistor de commutation, et dont l'électrode de commande reçoit des impulsions de synchronisation, caractérisé par le fait que l'anode du thyristor (8) est reliée par un condensateur de couplage (9) à l'extrémité côté base du circuit antiparallèle constitué par le trajet base-émetteur du transistor de commutation (10) et de la diode (13), par le fait que l'anode du thyristor (8) est reliée en outre en contre-réaction par une bobine d'arrêt (120) fonctionnant en impédance de rétroaction (12) à une prise du circuit de charge, et par le fait que la valeur de l'inductance de la bobine d'arrêt (120) est telle qu'elle constitue avec le condensateur de couplage (9) un circuit oscillant série dont la fréquence de résonance est inférieure à la fréquence du courant en dents de scie à générer.

2. Circuit selon la revendication 1, caractérisé par le fait qu'une bobine d'accumulation (17) est disposée entre l'anode du thyristor (8) et le point commun du condensateur de couplage (9) et de l'impédance de rétroaction (12, 120), et que l'impédance de la bobine d'accumulation est telle que le circuit résonant série constitué par la bobine d'accumulation (17) et le condensateur de couplage (9) a une fréquence propre telle qu'une période d'oscillation complète de ce circuit résonant est approximativement égale au quadruple du temps nécessaire à l'extinction du courant de base et à la dissipation de la charge d'espace de base du transistor de commutation (11) pendant le processus de coupure.

3. Circuit selon la revendication 1 ou 2, caractérisé par le fait que la base du transistor de commutation (10) est reliée par un circuit série comprenant une résistance (18) et un condensateur (19) à une borne de sortie d'un circuit d'alimentation en courant de tout l'appareil.

4. Circuit selon l'une des revendications 1 à 3, caractérisé par le fait que la base du transistor de commutation (10) est reliée à un ou plusieurs circuits de protection (21) court-circuitant la base par rapport à l'émetteur du transistor de commutation (10) en cas de panne de l'appareil.

Figur 1

Figur 2